# DEMANDE DE BREVET EUROPEEN

(11) **EP 2 006 901 A2**
(43) Date de publication de la demande: **24.12.2008**
(21) Numéro de dépôt: 08354040.1
(22) Date de dépôt: 17.06.2008
(51) Int. Cl.: H01L 21/768, H01L 23/532

(54) **Procédé de fabrication d'une connexion électrique à base de nanotubes de carbone**

(30) Priorité: 22.06.2007 FR 0704464
(71) Demandeur: Commissariat à l'Energie Atomique, 75015 Paris (FR)
(72) Inventeur: Coiffic, Jean-Christophe, 38000 Grenoble (FR)
(74) Mandataire: Jouvray, Marie-Andrée

(57) **Abrégé**

Au moins un orifice, comportant un fond et des parois latérales est formé dans une couche (5) en matériau isolant séparant deux couches (4, 12) en matériau métallique. Une couche de catalyseur (9) est ensuite déposée. Puis une couche inhibitrice (11) est formée par dépôt directionnel sur les parois de l'orifice et sur la couche en matériau isolant (5), laissant libre uniquement ta partie de la couche de catalyseur (9) qui est disposée dans le fond de l'orifice. Des nanotubes sont ensuite formés dans ledit orifice et connectent électriquement les deux couches (4, 12) en matériau métallique,

## Description

### Domaine technique de l'invention

L'invention est relative à un procédé de fabrication d'une connexion électrique entre deux couches en matériau métallique séparées par une couche en matériau isolant, procédé comportant:
- la formation dans la couche en matériau isolant d'au moins un orifice comportant un fond et des parois latérales,
- le dépôt d'une couche de catalyseur et
- la croissance des nanotube dans ledit orifice, les nanotubes reliant électriquement les deux couches en matériau métallique

### État de la technique

Les nanotubes de carbone font actuellement l'objet d'un effort important de recherche car leur structure cylindrique monoatomique leur confère des propriétés exceptionnelles à l'échelle nanométrique. Une application prometteuse consiste à utiliser les nanotubes dans les interconnexions, notamment dans l'industrie de la microélectronique, comme décrit par Nihei et al. (« Electrical Properties of Carbon nanotube Bundles for Future Via Interconnects » Japanese Journal of Applied Physics Vol. 44 N°4A, 2005 pp1626-1628). Ces interconnexions sont constituées par deux lignes de métal conductrices, actuellement en cuivre, situées l'une au-dessus de l'autre, formant ainsi deux niveaux métalliques reliés par des ponts conducteurs appelés vias.

Pour supporter les contraintes imposées par la réduction des dimensions ajoutée à une complexification des paramètres d'intégration, il est envisagé d'utiliser des nanotubes de carbone comme fils nanométriques métalliques pour les interconnexions. Ceux-ci possèdent en effet des propriétés intrinsèques très intéressantes par rapport au cuivre.

Cependant, un problème important reste lié à la localisation du catalyseur, nécessaire à la formation des nanotubes, uniquement sur les zones métalliques du niveau d'interconnexion métallique inférieur. Dans l'article précité de Nihei et al., le catalyseur est déposé après la formation des orifices d'interconnexion, c'est-à-dire des vias. Le catalyseur, une couche de cobalt, est déposé au fond des orifices par la technique de décollement (« lift-off ») et évaporation par un faisceau d'électron. Cette approche impose de réussir à éliminer le catalyseur et la barrière d'anti-diffusion sur la partie supérieure de la structure sous peine d'avoir des croissances parasites de nanotubes de carbone ainsi que des courts-circuits entre les niveaux d'interconnexion. L'article précité reste cependant très vague sur les procédés d'intégration au niveau industriel.

L'utilisation d'une gravure ionique, a été décrite par Duesberg et al. dans l'article « Growth of Isolated Carbon Nanotubes with Lithographically Defined Diameter and Location » (Nanoletters 2003, vol. 3, n°2, pp 257-259). Cependant, cette approche engendre de nombreux problèmes et notamment sa difficulté à être intégrée dans une filière industrielle.

Le document US-A-2003/0179559, décrit la réalisation d'une structure simple, dans laquelle un catalyseur (Fe, Ni, Y, Co, Pt) est déposé dans le fond des vias sans toutefois expliciter la manière dont le catalyseur est sélectivement déposé ou laissé au fond des orifices. Cette approche ne permet pas d'intégrer des nanotubes dans une structure double damascène, structure particulièrement avantageuse dans laquelle l'orifice du via et de la couche métallique suivante sont réalisés directement au sein de la couche d'isolation. Cette technique permet la réalisation de structures d'interconnexion des noeuds technologiques avancés en évitant des étapes fastidieuses de photolithographie.

Ce document décrit également la réalisation de nanotubes de carbone au sein d'une structure autorisant une intégration avec la technique double damascène. Dans ce cas, le dépôt du catalyseur est effectué avant la formation des vias. Ainsi, le matériau isolant, au-dessus du premier niveau métallique, est structuré afin de définir les zones où le catalyseur et donc les nanotubes sont recherchés. Cette intégration permet effectivement la réalisation d'une structure double damascène, mais présente néanmoins de nombreux inconvénients du fait de l'intégration du catalyseur avant la formation des vias. Cette approche devient alors particulièrement difficile à intégrer dans une utilisation industrielle avec une forte densité d'intégration.

### Objet de l'invention

L'invention a pour objet un procédé de fabrication qui soit facile à mettre en oeuvre, tout en étant compatible avec une intégration dans une structure de type double damascène.

Selon l'invention, ce but est atteint par un procédé selon les revendications annexées et plus particulièrement par un procédé qui comporte, entre le dépôt du catalyseur et la croissance des nanotubes, le dépôt directionnel d'une couche inhibitrice sur les parois latérales de l'orifice et sur la couche en matériau isolant, laissant libre uniquement la partie de la couche de catalyseur qui est disposée dans le fond de l'orifice.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 4 représentent de manière schématique, en coupe, les principales étapes de réalisation d'une structure d'interconnexion selon l'invention,
- les figures 5 à 7 représentent de manière schématique, en coupe, trois variantes de réalisation d'une structure d'interconnexion selon l'invention.

### Description de modes de réalisation préférentiels de l'invention

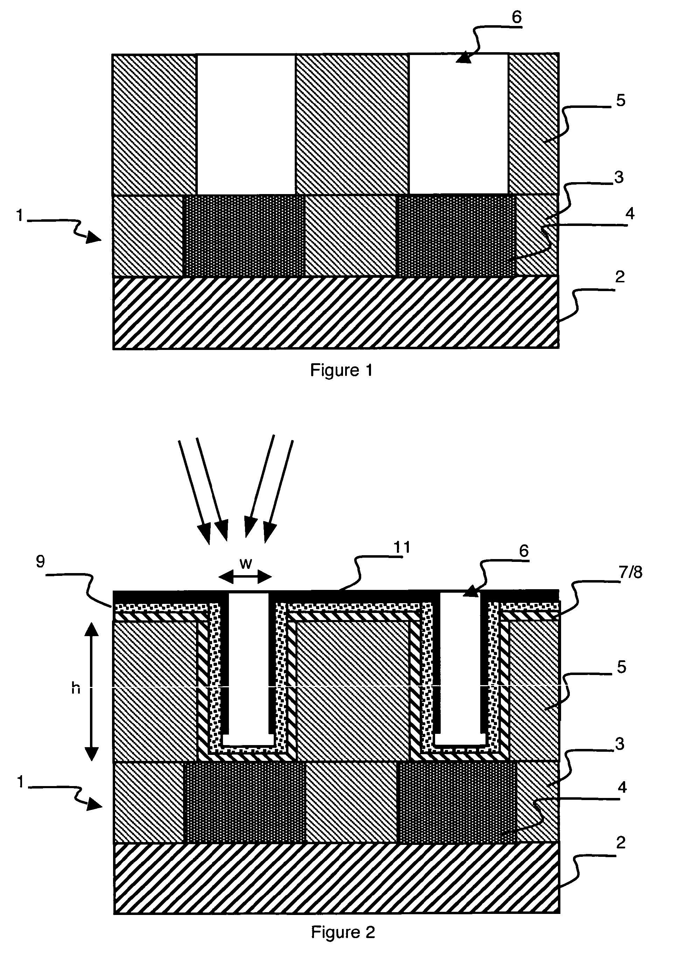

Comme illustré sur la figure 1, un premier niveau métallique 1 est réalisé sur un support 2. Le support 2 est par exemple constitué par un substrat de silicium et peut comporter une pluralité de couches. Le premier niveau métallique 1 est réalisé de manière classique et comporte une alternance entre un premier matériau isolant 3 et un premier matériau métallique 4. Le premier matériau métallique 4 forme ainsi des motifs au sein du premier matériau isolant 3, sur toute sa hauteur. Le premier matériau métallique 4 est par exemple en Cu, Al, W, Ag, Pt, Pd, Ti, TiN, Ta, TaN, Mo ou un de leurs alliages. Le premier matériau isolant 3 est réalisé dans un matériau ayant, de préférence, une constante diélectrique faible, par exemple de l'oxyde de silicium. Les épaisseurs des couches 3 et 4 sont typiquement celles utilisées dans une structure d'interconnexion métallique conventionnelle.

Une couche 5 en matériau isolant est alors déposée sur le premier niveau métallique 1. Cette couche 5 en matériau isolant est ensuite structurée, par toute technique adaptée, par exemple par photolithographie et gravure, de façon à former au moins un orifice 6 et ainsi à libérer l'accès à certains motifs en premier matériau métallique 4. Dans un premier mode de réalisation, la structuration de la couche 5 en matériau isolant permet de créer des orifices ou vias 6 sous la forme d'évidements ayant des parois latérales sensiblement verticales et rectilignes sur toute la hauteur de la couche 5 en matériau isolant.

Après structuration de la couche 5 en matériau isolant, le fond des vias 6 est alors matérialisé par des zones en premier matériau métallique 4 du premier niveau métallique 1. La forme des vias 6 est, de manière conventionnelle, carrée ou ronde, mais peut également présenter des formes diverses.

Comme illustré sur la figure 2, une couche d'accroche 7 et/ou une couche barrière 8 est ensuite, avantageusement, déposée sur l'ensemble de la structure. La couche d'accroche 7 permet de renforcer l'adhérence de la couche barrière 8 sur la couche 4. La couche d'accroche 7 est, par exemple, en Ta, TaN, TiN, Ti, Al, Ru, Mn, Mo, Cr, son épaisseur est avantageusement inférieure à 10nm et peut aller jusqu'au dépôt d'une couche atomique. La couche barrière 8, généralement utilisée pour éviter l'interdiffusion d'un catalyseur 9 avec le premier matériau métallique 4, est par exemple en Al, Al₂O₃, TiN, Ti, Ta, TaN, Mn, Ru, Mo. La couche barrière 8 peut également être auto-positionnée par dépôt chimique et auto-catalytique (« electroless » en anglais), c'est-à-dire qu'elle ne se dépose que sur les zones en premier matériau métallique 4. La couche barrière 8 est alors, par exemple, en CoWP, CoWB, CoWP/B, NiMoP, NiMoB ou tout métal et leurs alliages. La couche barrière 8 peut également être formée par une multicouche. La couche d'accroche 7 et la couche barrière 8 sont déposées par toute technique adaptée, par exemple, par évaporation, pulvérisation sous plasma de gaz neutre, par exemple de l'argon, de l'hélium ou de l'hydrogène. Avantageusement, si le premier matériau métallique 4 est en cuivre, une couche d'accroche 7 en Tantale (Ta) et une couche barrière 8 pouvant être en TaN, TiN ou Ru seront utilisées.

Une couche de catalyseur 9, permettant la croissance des nanotubes 10, est ensuite déposée sur la structure. Le catalyseur 9 est par exemple en Co, Ni, Fe, Al, Al₂O₃. Au catalyseur, il peut être ajouté un élément stabilisant par exemple Mo, Y, MgO, Mn, Pt. Le catalyseur peut également être auto-positionné et est alors, par exemple, en CoWP, CoWP/B, NiMoB, leurs oxydes ou leurs alliages. Dans certains cas de figure, le catalyseur 9 et la couche barrière 8 sont confondus et sont par exemple en CoWP, CoWP/B, NiMoB.

Le catalyseur 9 peut également être déposé sous forme d'agrégats ou sous la forme de multicouche de différents matériaux. Le catalyseur est déposé, par exemple, par évaporation, pulvérisation d'une cible de matériau à déposer, pulvérisation cathodique, dépôt électrochimique.

Une couche inhibitrice 11, est ensuite déposée sur la structure. Cette couche inhibitrice permet de désactiver le catalyseur 9 dans les zones où des nanotubes 10 ne sont pas désirés. La couche inhibitrice 11 est déposée par dépôt directionnel, oblique, comme schématisé par les flèches sur la figure 2, de manière à recouvrir le catalyseur 9 excepté dans le fond des orifices 6. De cette manière, le catalyseur n'est laissé libre que dans le fond des orifices 6 tandis que la couche inhibitrice 11 recouvre le reste de la structure. Si des transistors sont intégrés sous la couche, il est avantageux de ne pas utiliser de l'or comme couche inhibitrice car l'or dégrade les performances des transistors.

La couche inhibitrice 11 peut être en matériau conducteur, par exemple en Al, Au, Pd, Ag, Ru, Cr, Ti, Cu, Pt, C, W, TiN, Mo, Si ou leurs alliages mais elle peut également être en matériau isolant, par exemple en Al₂O₃, MgO, SiO₂ SixNx, SiOC, TiO₂. La couche inhibitrice 11 a, préférentiellement, une épaisseur comprise entre 3 et 500nm, l'épaisseur étant adaptée en fonction de l'application visée. En effet, une couche inhibitrice 11 inférieure à 3 nm est généralement discontinue, d'autant plus pour les architectures non planes. Dans les interconnexions de type microélectronique, les orifices 6 ne dépassent pas 250 nm de largeur, les épaisseurs de couche inhibitrice 11 déposées sont adaptées pour éviter de boucher l'orifice.

Le dépôt de la couche inhibitrice 11 est réalisé par toute technique capable de réaliser un dépôt dirigé ou sous incidence. Le dépôt de la couche 11 est réalisé par exemple par les techniques d'évaporation ou de pulvérisation, par exemple, PVD « Physical Vapor Deposition », SIP « Self Induced Plasma », FIB « Focused Ion Beam ». La technique d'évaporation est préférentiellement choisie pour le dépôt de la couche inhibitrice 11. Plusieurs dépôts successifs, avec des angles différents (entre le flux de matière et l'axe du support) et/ou des conditions différentes peuvent être utilisés. Les angles sont choisis de manière à ce que la couche inhibitrice 11 ne soit pas déposée sur la partie de la couche de catalyseur 9 se trouvant au fond du via 6. La géométrie des orifices peut obliger à l'utilisation de dépôts sous incidence successifs avec des angles différents. Un moyen de pallier la perte de temps due aux multiples dépôts est l'utilisation d'un substrat tournant ayant des orifices 6 autour de l'axe d'arrivé de matière.

L'angle de dépôt optimum ϑ est défini par rapport aux dimensions de l'orifice 6. L'angle ϑ est défini par rapport à l'axe de l'orifice 6 et est donné par la formule ϑ = arctan(w/h) où w représente la longueur ou le diamètre de l'orifice 6 et h la hauteur de la couche 5. Ainsi, en réalisant des dépôts sous incidence ayant un angle supérieur à l'angle optimum ϑ, la couche inhibitrice ne se dépose pas dans le fond des orifices 6.

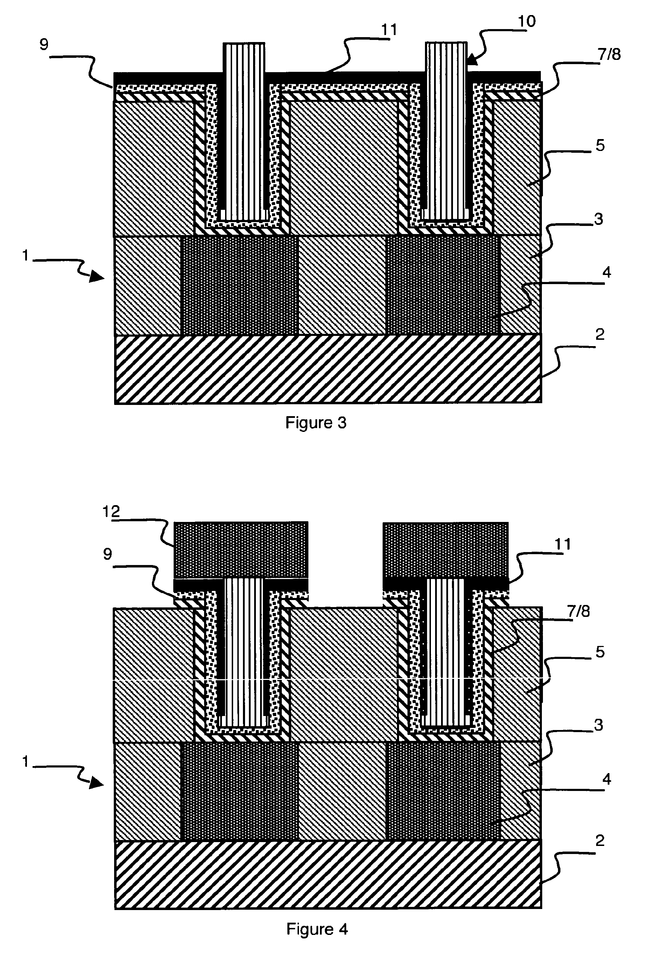

Comme illustré sur la figure 3, la croissance des nanotubes 10, de préférence de carbone, est alors réalisée. La croissance des nanotubes 10 est réalisée de façon classique à partir du catalyseur 9 déposé sur le premier matériau métallique 4 au fond des orifices 6. La croissance des nanotubes 10 peut être réalisée par toute technique adaptée, par exemple par dépôt chimique en phase vapeur CVD, dépôt chimique en phase vapeur assisté par plasma PECVD, Electron Cyclotron Resonance PECVD, dépôt chimique en phase vapeur avec filament à chaud, dépôt chimique en phase vapeur assisté laser... Préférentiellement, une technique permettant la croissance de nanotubes 10 de carbone à partir d'un catalyseur et à une température inférieure à 900°C est utilisée. Les gaz employés lors de la formation de nanotubes de carbone peuvent être du CO, C₂H₂, CH₄, Fe(C₅H₅)₂, du xylène, des métallocènes, les alcools à l'état gazeux et tous les gaz carbonés, H₂, NH₃, H₂O, O₂ ou un mélange de ces gaz. Le carbone peut également être apporté grâce à une sole en graphite, bombardée par un plasma.

Classiquement, la croissance des nanotubes 10 se fait à partir du catalyseur 9 disposé au fond des orifices 6, formé dans la couche 5 en matériau isolant. Sur les figures 3 à 6, les nanotubes schématisés par des traits parallèles et verticaux, mais tout en étant sensiblement verticale, leur orientation est en réalité plus libre. Les nanotubes 10 font saillie vers le haut hors des orifices 6.

Comme illustré sur la figure 4, le dépôt d'un deuxième matériau métallique 12 est ensuite réalisé, puis structuré, de façon classique. Le deuxième matériau métallique 12 est par exemple en Cu, Au, Al, W, Ag, Pt, Pd, Ti, TiN, Ta, TaN, Mn, Ru, Mo ou un de leurs alliages et son épaisseur est préférentiellement comprise entre 5 nm et 100 µm. Avec la structuration du deuxième matériau métallique 12, les couches d'accroche 7, de barrière 8 et de catalyseur 9 sont également éliminées. La gravure des motifs en deuxième matériau métallique s'arrêtant sur la couche 5, il n'y a pas de contact électrique parasite possible entre deux orifices adjacents au moyen de l'une de ces couches 7, 8, 9. Les couches en premier 4 et deuxième 12 matériau métallique sont ainsi connectées électriquement au moyen des nanotubes 10. Dans ce mode de réalisation, la connexion des deux matériaux métalliques 4, 12 est réalisée par les parois externes des nanotubes 10.

L'empilement formé par la couche barrière 8, le catalyseur 9 et la couche inhibitrice 11, pouvant être électriquement conducteur, est également gravé en même temps que les motifs en deuxième matériau métallique 12. Les motifs en deuxième matériau métallique 12 peuvent présenter des formes et orientations variées.

La couche en deuxième matériau métallique 12 a de préférence une épaisseur suffisante, de préférence supérieure à 30nm, pour avoir une tenue mécanique suffisante pour permettre une éventuelle étape ultérieure de polissage mécano-chimique. Cette étape de polissage mécano-chimique est avantageusement utilisée afin de sectionner les extrémités supérieures des nanotubes 10 incorporées dans la couche en matériau métallique 12 et permettre ainsi l'accès aux parois internes des nanotubes.

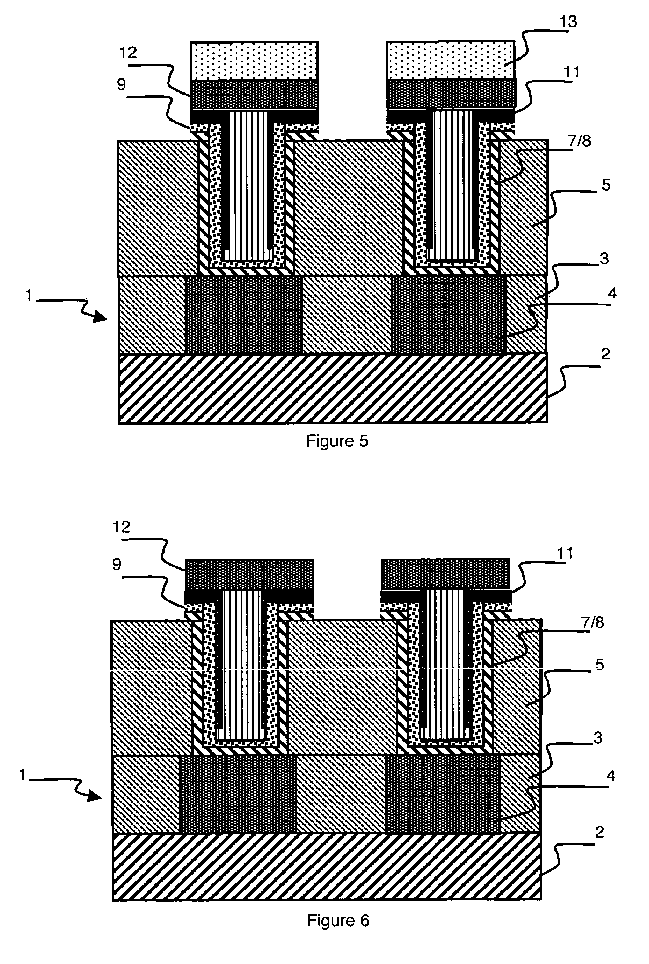

Comme illustré sur la figure 5, le dépôt d'un troisième matériau métallique 13 peut alors être réalisé afin de former une surface conductrice supérieure et connecter les parois internes des nanotubes 10. Le troisième matériau métallique est par exemple en Cu, Al, Au, W, Ag, Pt, Pd, Ti, TiN, Ta, TaN. La structuration de l'ensemble formé par les deuxième 12 et troisième 13 matériaux métalliques ainsi que par la couche barrière 8, le catalyseur 9 et la couche inhibitrice 11 est réalisée, comme précédemment, par toute technique adaptée. Dans cette variante, le contact électrique entre les niveaux métalliques 4, 12, 13 est réalisé en utilisant simultanément un contact électrique par l'intermédiaire de la surface externe des nanotubes 10 et de leur surface interne.

Dans une autre variante de réalisation, illustrée par la figure 6, la couche inhibitrice 11 étant en matériau conducteur, elle permet le dépôt du deuxième matériau métallique 12 par voie électrochimique. Les nanotubes 10 de carbone et la surface inférieure du via 6 étant conducteurs, ces derniers peuvent donc aussi participer au dépôt électrochimique mais de manière moindre. De cette manière, le deuxième matériau métallique 12 remplit au moins partiellement le via 6 et forme également la couche en deuxième matériau métallique 12 au-dessus de la couche 5. Dans ce mode de réalisation, la couche inhibitrice 11 est choisie de manière à être très électriquement conductrice afin de faciliter la mise en oeuvre du dépôt électrochimique, par exemple de l'aluminium ou de l'or. Le matériau déposé par dépôt électrochimique est préférentiellement du cuivre, mais peut être, par exemple, en Al, Au, Pd, Ag, Ni, Fe, Cr, Ti, Pt, C, Co, Mo, Ru, ou un alliage de ces derniers. Le matériau déposé par dépôt électrochimique peut aussi être un composé à transfert de charge, comme les sels de Bechgaard, tels que les sels à base de tetra-methyl tetra selenafulvalene (TMTSF) ou les sels de biséthyldithio-tétrathiafulvalène (BEDT-TTF) ou encore des sels de tetra-methyl tétrathiafulvalène (TMTTF). Avantageusement, lorsque le dépôt remplit complètement les interstices entre les nanotubes, il permet d'augmenter la conductivité de la structure d'interconnexion. De plus l'interconnexion est mécaniquement renforcée pour assurer, par exemple, une étape de polissage mécano-chimique.

Comme dans les modes de réalisation précédents, la couche en deuxième matériau métallique 12 peut être soumise à une gravure additionnelle, par exemple par polissage mécano-chimique ou gravure sèche, pour accéder aux parois internes des nanotubes 10. Ainsi, comme sur la figure 5, un troisième matériau métallique 13 peut être déposé au-dessus du deuxième matériau métallique 12.

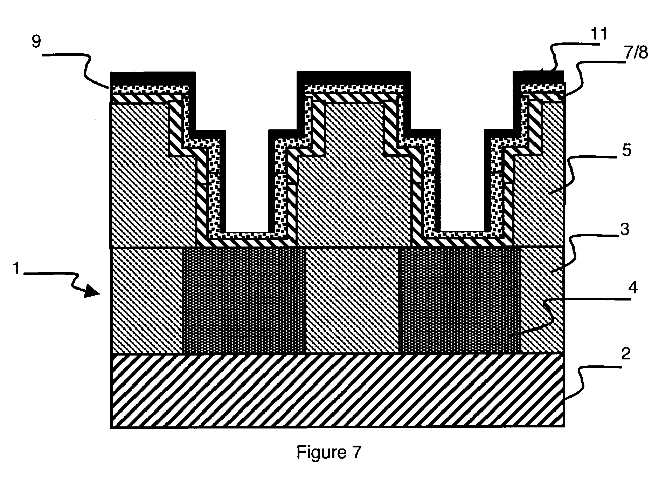

Dans une variante du mode de réalisation de la figure 2, illustré à la figure 7, la structuration de la couche 5 en matériau isolant est réalisée de manière à pouvoir utiliser la technique double damascène. La structuration de la couche 5 en matériau isolant consiste à former un orifice 6 qui représente le futur via mais également le volume destiné à être occupé par le deuxième matériau métallique 12. L'orifice 6 comporte ainsi un épaulement et a une section plus importante dans sa partie supérieure. Cette structuration de la couche 5 en matériau isolant est réalisée de manière classique. Dans cette variante, le dépôt directionnel de la couche inhibitrice 11 est réalisé de manière à ce que la couche inhibitrice tapisse également la section élargie de l'orifice 6, sans toutefois obstruer le fond de l'orifice. Ceci est, par exemple, réalisé par un choix judicieux de l'angle de pulvérisation par rapport à la surface de la structure. Le dépôt du catalyseur est avantageusement réalisé avec une incidence inférieure à la largeur de l'ouverture de l'orifice. Par ailleurs, l'épaisseur du dépôt est également adaptée aux dimensions des orifices 6.

Après croissance des nanotubes à partir du fond des orifices 6 et dépôt d'un matériau métallique remplissant au moins les orifices 6, une étape classique de polissage mécano-chimique permet de localiser le deuxième niveau métallique uniquement dans les orifices 6 de la couche 5 en matériau isolant prévus à cet effet.

Cette approche est particulièrement avantageuse pour réaliser des interconnexions présentant des densités d'intégration fortes.

Cette variante de réalisation peut être couplée avec les variantes de réalisation précédentes pour avoir accès aux parois internes des nanotubes 10 et pour remplir les vias 6.

## Revendications

1. Procédé de fabrication d'une connexion électrique entre deux couches (4, 12) en matériau métallique séparées par une couche (5) en matériau isolant, procédé comportant:
- la formation dans la couche (5) en matériau isolant d'au moins un orifice (6) comportant un fond et des parois latérales,
- le dépôt d'une couche de catalyseur (9) et
- la croissance des nanotubes (10) dans ledit orifice, les nanotubes reliant électriquement les deux couches (4, 12) en matériau métallique,
procédé **caractérisé en ce qu'**il comporte, entre le dépôt du catalyseur et la croissance des nanotubes (10), le dépôt directionnel d'une couche inhibitrice (11) sur les parois latérales de l'orifice (6) et sur la couche (5) en matériau isolant, laissant libre uniquement la partie de la couche de catalyseur (9) qui est disposée dans le fond de l'orifice (6).

2. Procédé selon la revendication 1, **caractérisé en ce qu'**une couche barrière (7) est déposée avant dépôt du catalyseur (9).

3. Procédé selon l'une des revendications 1 et 2, **caractérisé en ce qu'**une couche d'accroche (8) est déposée avant dépôt du catalyseur (9).

4. Procédé selon l'une quelconque des revendications 1 à 3, **caractérisé en ce que** la couche inhibitrice (11) est en matériau conducteur choisi parmi Al, Au, Pd, Ru, Cr, Ti, Cu, Pt, C, W, TiN, Mo, Si ou un de leurs alliages.

5. Procédé selon l'une quelconque des revendications 1 à 3, **caractérisé en ce que** la couche inhibitrice (11) est en matériau isolant choisi parmi Al₂O₃, MgO, SiO₂, SixNx, SiOC, TiO₂.

6. Procédé selon l'une quelconque des revendications 1 à 5, **caractérisé en ce que** la couche inhibitrice (11) a une épaisseur comprise entre 3 et 500nm.

7. Procédé selon l'une quelconque des revendications 1 à 6, **caractérisé en ce que** la couche inhibitrice (11) est déposée par évaporation ou pulvérisation, PVD, SIP, FIB.

8. Procédé selon l'une quelconque des revendications 1 à 7, **caractérisé en ce qu'**après croissance des nanotubes (10), l'orifice (6) est au moins partiellement rempli par le matériau métallique, constituant la seconde couche en matériau métallique (12).

9. Procédé selon la revendication 8, **caractérisé en ce que** le second matériau métallique remplissant l'orifice (6) est déposé par voie électrochimique.

10. Procédé selon l'une quelconque des revendications 1 à 9, **caractérisé en ce que** les nanotubes (10) sont des nanotubes de carbone.

11. Procédé selon l'une quelconque des revendications 1 à 9, **caractérisé en ce que** l'orifice (6) comporte un épaulement ayant un section élargie dans sa partie supérieure.
